(19) **Europäisches Patentamt / European Patent Office / Office européen des brevets**

(11) **EP 3 739 699 B1**

(12) **EUROPEAN PATENT SPECIFICATION**

(45) Date of publication and mention of the grant of the patent:
**06.09.2023  Bulletin 2023/36**

(21) Application number: **19763259.9**

(22) Date of filing: **28.02.2019**

(51) International Patent Classification (IPC):
**H04B 10/073** (2013.01)  **H04B 10/564** (2013.01)
**H01S 5/068** (2006.01)  **H01S 5/00** (2006.01)

(52) Cooperative Patent Classification (CPC):
**H01S 5/06825; H01S 5/0021; H04B 10/073;**
H01S 5/06812; H04B 10/564

(86) International application number:
**PCT/JP2019/007889**

(87) International publication number:
**WO 2019/172086 (12.09.2019 Gazette 2019/37)**

(54) **LIFE PREDICTION METHOD AND LIFE PREDICTION DEVICE FOR OPTICAL MODULES**

**LEBENSZEITVORHERSAGEVERFAHREN UND LEBENSZEITVORHERSAGEVORRICHTUNG FÜR OPTISCHE MODULE**

**PROCÉDÉ DE PRÉDICTION DE DURÉE DE VIE ET DISPOSITIF DE PRÉDICTION DE DURÉE DE VIE POUR MODULES OPTIQUES**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.03.2018  PCT/JP2018/009066**

(43) Date of publication of application:
**18.11.2020  Bulletin 2020/47**

(73) Proprietor: **Mitsubishi Electric Corporation**
**Tokyo 100-8310 (JP)**

(72) Inventors:
- **SUEHIRO, Takeshi**
  **Tokyo 100-8310 (JP)**
- **NAKURA, Kenichi**
  **Tokyo 100-8310 (JP)**
- **SATO, Hiromu**
  **Tokyo 100-8310 (JP)**
- **ISHIDA, Kazuyuki**
  **Tokyo 100-8310 (JP)**
- **OHASHI, Hideaki**
  **Tokyo 100-8310 (JP)**
- **IMADA, Noriyuki**
  **Tokyo 100-8310 (JP)**
- **HORAYAMA, Nanako**
  **Tokyo 100-8310 (JP)**

(74) Representative: **Pfenning, Meinig & Partner mbB**
**Patent- und Rechtsanwälte**
**Theresienhöhe 11a**
**80339 München (DE)**

(56) References cited:
| | |
|---|---|
| JP-A- H09 116 231 | JP-A- 2014 107 790 |
| JP-A- 2014 107 790 | JP-A- 2014 212 234 |
| JP-A- 2014 212 234 | US-A- 5 754 576 |
| US-A1- 2004 167 747 | |

EP 3 739 699 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Field

The present invention relates to a life prediction method and a life prediction device for an optical module for predicting the life of the optical module that is used in optical communication.

Background

Optical communication has been applied to various systems because of its characteristics such as long transmission distance, high transmission speed, and high electromagnetic noise immunity. In a case where an optical communication system requires high reliability, an optical module that is used in the optical communication system also requires high reliability and needs preventive maintenance. An optical module includes a light source, and modulates and outputs light emitted from the light source using an electric signal generated according to information to be transmitted. An optical module that uses a laser diode as the light source typically has a function of keeping the optical output constant by controlling a bias current that is applied to the laser diode. The optical output decreases as the laser diode deteriorates even when an equal bias current is applied. Therefore, in order to keep the optical output constant, larger values of bias current should be applied as the laser diode deteriorates. Utilizing this principle, Patent Literature 1 discloses a technique for estimating the deterioration of a laser diode based on the value of bias current applied.

Document US 2004/167747 A1 discloses a laser diode management apparatus which decides a time to replace a laser diode, comprising: an operating-current value acquiring unit that acquires a value of an operating current of the laser diode; a laser intensity acquiring unit that acquires a value of intensity of laser light output from the laser diode; and a replacement period determining unit that determines a replacement period of the laser diode based on the value of the operating current and the values intensity of the laser light, and outputs at least one of a first notification that indicates that the laser diode needs replacement and a second notification that indicates that the laser diode needs replacement in near future, based on a result of the determination.

Document JP 2014 107790 A discloses a method for prediction of performance deterioration of a monitoring target device when a bias change rate of the monitoring target device is not monotonous.

Citation List

Patent Literature

Patent Literature 1: Japanese Patent Application Laid-open No. H09-116231

Summary

Technical Problem

However, in the technique described in Patent Literature 1, the predictive value of the deterioration time, which is the time at which the laser diode is determined to have deteriorated, is obtained by linear approximation based on bias current values at two past times. For this reason, it is difficult to use the technique described in Patent Literature 1 to accurately estimate the life of an optical module, that is, the deterioration time of the laser diode. In a typical example, the bias current increases exponentially with elapsed time. In this case, according to the method described in Patent Literature 1, the deterioration time can be predicted with some degree of accuracy at a time near the true deterioration time, but the predictive value of the deterioration time deviates from the true deterioration time as the time at which the deterioration time is predicted is farther from the true time.

The present invention has been made in view of the above, and an object thereof is to provide a life prediction method for an optical module capable of predicting the life of the optical module quickly and accurately.

Solution to Problem

The invention is set out in the appended set of claims.

Advantageous Effects of Invention

The present invention can achieve the effect of predicting the life of the optical module quickly and accurately.

Brief Description of Drawings

FIG. 1 is a diagram illustrating an exemplary configuration of a life prediction device according to a first embodiment of the invention.
FIG. 2 is a flowchart illustrating an exemplary procedure in the life prediction device according to the first embodiment.
FIG. 3 is a diagram illustrating an exemplary configuration of a life prediction device according to a second, alternative embodiment of the invention.
FIG. 4 is a flowchart illustrating an exemplary procedure in the life prediction device according to the second embodiment.
FIG. 5 is a diagram illustrating an exemplary configuration of a life prediction device according to a third preferred embodiment.
FIG. 6 is a diagram illustrating an exemplary hardware configuration of a life prediction device.
FIG. 7 is a diagram illustrating another exemplary hardware configuration of a life prediction device.
FIG. 8 is a diagram illustrating a configuration of a life prediction device not falling under the scope of the invention.
FIG. 9 is a diagram schematically illustrating a life prediction function F(T) that is based on the temperature characteristics of the laser according to the fourth embodiment.
FIG. 10 is a flowchart illustrating an exemplary procedure in the life prediction device according to the example of fig. 8.

Description of Embodiments

Hereinafter, a life prediction method and a life prediction device for an optical module according to embodiments of the present invention will be described in detail with reference to the drawings. The present invention is not limited to the embodiments.

First Embodiment.

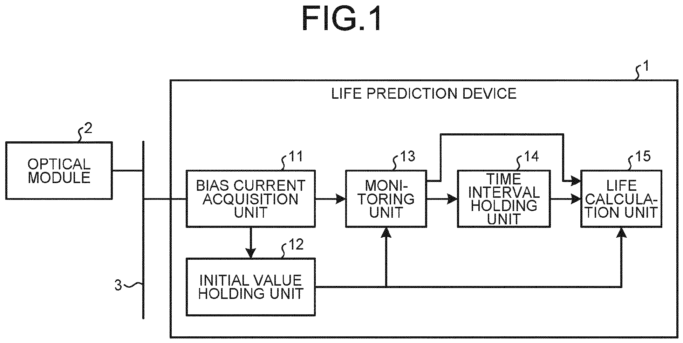

FIG. 1 is a diagram illustrating an exemplary configuration of a life prediction device 1 according to the first embodiment of the present invention. As illustrated in FIG. 1, the life prediction device 1 of the present embodiment is connected to an optical module 2 by a bus 3. The optical module 2 includes a laser diode (not illustrated), and controls a bias current that is applied to the laser diode so as to keep the optical output constant. That is, the optical module 2 keeps the optical output constant by controlling a bias current that is applied to the laser diode. The bus 3 is, for example, an I2C bus, but the bus 3 is not limited to this. The form of connection between the optical module 2 and the life prediction device 1 is not limited to the connection using the bus 3.
As illustrated in FIG. 1, the life prediction device 1 includes a bias current acquisition unit 11, an initial value holding unit 12, a monitoring unit 13, a time interval holding unit 14, and a life calculation unit 15. The bias current acquisition unit 11 periodically acquires, from the optical module 2 via the bus 3, a bias current value, i.e. a current value of the bias current that is applied to the laser diode. Small form factor (SFF), which is a multi-source agreement (MSA: standards agreed between manufacturers) on optical modules, specifies that monitor information of an optical module including a bias current value can be acquired by an I2C interface. For example, the bias current acquisition unit 11 can acquire the bias current by acquiring monitor information according to the SFF and extracting a bias current value from the monitor information. The bias current acquisition unit 11 can periodically acquire the bias current using a timer that is reset every time a bias current value is acquired, for example. The bias current acquisition unit 11 outputs the bias current value indicated by the acquired bias current value information to the monitoring unit 13 and the initial value holding unit 12.
The initial value holding unit 12 holds an initial bias current value which is a current value of the initial bias current, and outputs the held initial bias current value to the monitoring unit 13 and the life calculation unit 15. In a case where the life prediction device 1 is started after the optical module 2 is turned on, the initial bias current value is the first bias current value received from the bias current acquisition unit 11 after the life prediction device 1 is started. In a case where the optical module 2 is turned on after the life prediction device 1 is started, the initial bias current value is the first bias current value received from the bias current acquisition unit 11 after the optical module 2 is turned on. Note that the initial bias current value is not limited to the examples described above, and may be any bias current value at the start of the life calculation processing.
The monitoring unit 13 obtains a difference value that is the difference between the bias current value output from the bias current acquisition unit 11 and the initial bias current value output from the initial value holding unit 12. The monitoring unit 13 detects the occurrence of a carry (described later) by monitoring the number of digits of the obtained difference value, and when a carry occurs, notifies the time interval holding unit 14 of the occurrence. A carry means that the number of digits of a current value is greater than the number of digits of a previous value. That is, the monitoring unit 13 calculates the number of digits of the difference value between the bias current value and the initial bias current value, and determines whether there is an increase in the number of digits. When a carry occurs, the monitoring unit 13 notifies the life calculation unit 15 of the number of digits of the difference value. The time interval holding unit 14 holds a timer for measuring the time interval at which a carry occurs, and calculates and holds the time interval for carry occurrence using the held timer, based on the notification from the monitoring unit 13. The time interval holding unit 14 notifies the life calculation unit 15 of the time interval for carry occurrence. The life calculation unit 15 calculates the remaining life of the optical module 2 as the life of the optical module 2 using the time interval for carry occurrence, the number of digits of the difference value, the threshold of the bias current, and the initial bias current value. The threshold of the bias current is the threshold of the bias current for determining that the optical module 2 has deteriorated. When the bias current is equal to or greater than this threshold, it is determined that the optical module 2 has deteriorated, that is, the optical module 2 has reached the end of its life. Details of the processing in the life calculation unit 15 will be described later.

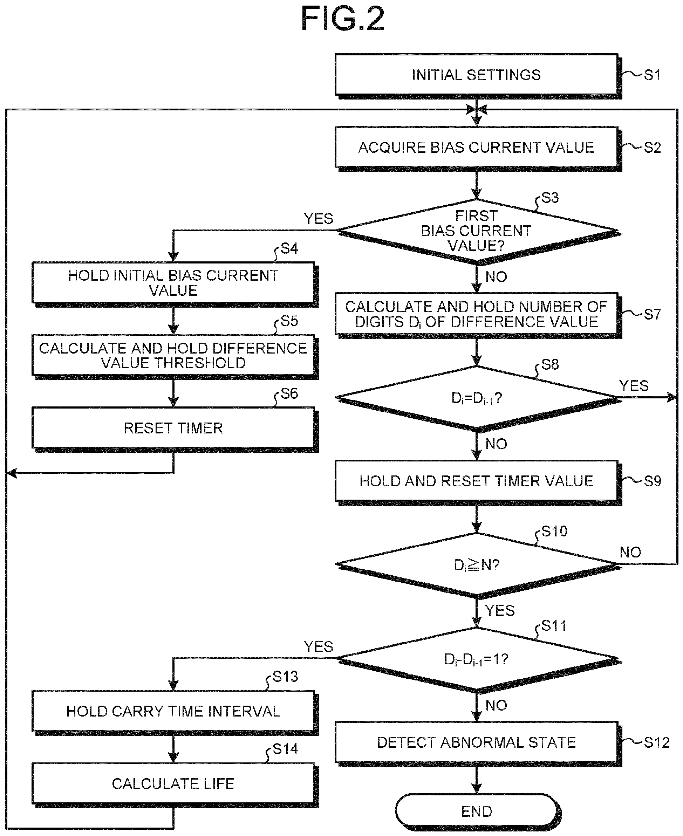

Next, a life prediction method for the optical module 2 by the life prediction device 1 of the present embodiment will be described. FIG. 2 is a flowchart illustrating an exemplary procedure in the life prediction device 1.

The life prediction device 1 first configures initial settings (step S1). As initial settings, the bias current threshold is set in the life calculation unit 15, and the effective carry threshold N is set in the monitoring unit 13. The bias current threshold may be set by the life calculation unit 15 reading the bias current threshold stored in advance in the life prediction device 1, or may be input from outside after the life prediction device 1 is started. Similarly, the effective carry threshold N may be set by the monitoring unit 13 reading the effective carry threshold N stored in advance in the life prediction device 1, or may be input from outside after the life prediction device 1 is started. Although the present embodiment describes an example in which the bias current threshold is set, a difference value threshold corresponding to a value obtained by subtracting the initial bias current value from the bias current threshold may be set in the life prediction device 1. In this case, step S5 described later need not be performed.

The bias current acquisition unit 11 of the life prediction device 1 acquires a bias current value from the optical module 2 (step S2). The life prediction device 1 determines whether the acquired bias current value is the first bias current value acquired by the bias current acquisition unit 11. In the case of the first bias current value (step S3: Yes), the life prediction device 1 holds the acquired bias current value as the initial bias current value (step S4). Specifically, when the acquired bias current value is the first bias current value acquired by the bias current acquisition unit 11, the bias current acquisition unit 11 passes the acquired bias current value to the initial value holding unit 12, and the initial value holding unit 12 holds the bias current value received from the bias current acquisition unit 11 as the initial bias current value. Alternatively, the bias current acquisition unit 11 passes the bias current value to the initial value holding unit 12 regardless of the number of bias current values acquired so far, and the initial value holding unit 12 holds the first bias current value acquired from the bias current acquisition unit 11 as the initial bias current value. The initial value holding unit 12 passes the initial bias current value to the life calculation unit 15.

The life calculation unit 15 calculates and holds the difference value threshold $D_{limit}$ by subtracting the initial bias current value from the bias current threshold (step S5). The time interval holding unit 14 resets the timer for measuring the time interval at which a carry occurs (step S6). Specifically, for example, step S6 is executed when the monitoring unit 13 instructs the time interval holding unit 14 to reset the timer in response to receiving the first bias current value from the bias current acquisition unit 11 that passes acquired bias current values to the monitoring unit 13. After step S6, the processing returns to step S2. As described above, because bias current values are acquired periodically, step S2 is periodically performed, and step S3 and subsequent steps are performed each time step S2 is performed.

When it is determined in step S3 that the acquired bias current value is not the first bias current value acquired by the bias current acquisition unit 11 (step S3: No), the monitoring unit 13 calculates and holds the number of digits $D_i$ of the difference value (step S7). The monitoring unit 13 holds the number of digits $D_i$ at least until the next execution of step S7. Here, "$D_i$" is the number of digits of the difference value calculated using the i-th bias current acquired, where "i" is an integer indicating the total number of executions of step S2 including the latest execution. Because step S7 is executed after No is selected in step S3, step S7 is executed when i is two or more. In step S7, specifically, the monitoring unit 13 obtains a difference value by subtracting the initial bias current value output from the initial value holding unit 12 from the bias current acquired from the bias current acquisition unit 11, and calculates the number of digits $D_i$ of the obtained difference value. By managing the bias current value, the initial bias current value, and the difference value in binary notation, the calculation of the number of digits $D_i$ and the carry monitoring (described later) by hardware are facilitated.

The monitoring unit 13 determines whether the number of digits $D_i$ calculated in step S7 is equal to the number of digits $D_{i-1}$ calculated and held in the previous step S7 (step S8). Note that in the case of i=2, $D_{i-1}$, that is, $D_1$ has not been calculated. In the case of i=2, therefore, the monitoring unit 13 performs step S8 by assigning a preset value, e.g. zero, to $D_1$. When the number of digits $D_i$ is equal to the number of digits $D_{i-1}$ (step S8: Yes), the life prediction device 1 returns to step S2.

When the number of digits $D_i$ is not equal to the number of digits $D_{i-1}$ (step S8: No), the life prediction device 1 holds the timer value of the timer for measuring the time interval at which a carry occurs, and then resets the timer (step S9). Specifically, when No is selected in step S8, the monitoring unit 13 determines that a carry has been detected, notifies the time interval holding unit 14 of the detection of the carry, and notifies the life calculation unit 15 of the number of digits $D_i$. In response to being notified of the detection of the carry, the time interval holding unit 14 holds the timer value of the internal timer and resets the timer. Here, based on the premise that the bias current increases with the passage of time, it is determined that a carry has occurred when the number of digits $D_i$ is not equal to the number of digits $D_{i-1}$. If there is any abnormality such as an abnormality in data received from the optical module 2, the number of digits may be reduced. In such a case, No is selected in step S11 (described later), and an abnormal state is detected.

The monitoring unit 13 determines whether the number of digits $D_i$ is equal to or greater than the effective carry threshold N (step S10). When the number of digits $D_i$ is less than the effective carry threshold N (step S10: No), the processing returns to step S2. When the number of digits $D_i$ is equal to or greater than the effective carry threshold N (step S10: Yes), the monitoring unit 13 determines whether the value obtained by subtracting the number of digits $D_{i-1}$ from the number of digits $D_i$ is one (step S11). When the value obtained by subtracting the number of digits $D_{i-1}$ from the number of digits $D_i$ is not one (step S11: No), the monitoring unit 13 determines that the processing is in an abnormal state (step S12), and ends the processing. When it is determined that the processing is in an abnormal state, the monitoring unit 13 may transmit or display information for notifying the user of the abnormality.

When the value obtained by subtracting the number of digits $D_{i-1}$ from the number of digits $D_i$ is one (step S11: Yes), the monitoring unit 13 instructs the time interval holding unit 14 to hold the time interval $\Delta T$ that is the time interval for carry, and the time interval holding unit 14 holds the timer value held in step S9 as the time interval $\Delta T$ (step S13). Note that the time interval holding unit 14 does not need to update the time interval $\Delta T$ when the timer value is the same as the held time interval $\Delta T$. Further, the time interval holding unit 14 may keep holding the timer value obtained at the time of carry detection for a certain period of time, and calculate and hold the time interval $\Delta T$ by processing a plurality of held timer values. For example, the time interval holding unit 14 may calculate and hold the minimum value, average value, weighted average value, or the like of a plurality of held timer values as the time interval $\Delta T$. Alternatively, the time interval holding unit 14 may set the average value of the previous time interval $\Delta T$ and the latest timer value as the time interval $\Delta T$. The time interval holding unit 14 outputs the held time interval $\Delta T$ to the life calculation unit 15.

Next, the life calculation unit 15 calculates the remaining life of the optical module 2 using the difference value threshold $D_{limit}$ as a first threshold, the number of digits $D_i$, and the time interval $\Delta T$ (step S14). After step S14, the processing returns to step S2. In step S14, specifically, the life calculation unit 15 calculates the remaining life $T_L$ using Formula (1) below. The life calculation unit 15 may transmit information indicating the calculated remaining life $T_L$ to the outside.

$$T_L = (D_{limit} - D_i) \times \Delta T \dots \quad (1)$$

The life prediction method for the optical module 2 according to the present embodiment includes a first step of acquiring a current value of the bias current from the optical module 2, and a second step of holding an initial bias current value that is an initial current value of the bias current performed by the life prediction device 1. The life prediction method for the optical module 2 according to the present embodiment also includes, by the life prediction device 1, a third step of calculating the number of digits of a difference value between the bias current value and the initial bias current value, and determining whether there is an increase in the number of digits. The life prediction method for the optical module 2 according to the present embodiment further includes, by the life prediction device 1, a fourth step of calculating the time interval $\Delta T$ that is a time interval at which occurrence of the increase in the number of digits is detected, and a fifth step of estimating a life of the optical module using the time interval $\Delta T$, a first threshold, and the number of digits.

The bias current of the optical module 2 changes exponentially with time. In an exponential function, the number of digits changes linearly. In the present embodiment, as described above, the life prediction device 1 approximates the bias current with an exponential function with respect to time, thereby estimating the remaining life of the optical module 2 based on the number of digits of the difference value between the bias current and the initial bias current and the carry time interval for the difference value. Consequently, the remaining life of the optical module 2 can be estimated accurately, as compared with the case where the remaining life is calculated by linear approximation between two times.

Further, as described above, when the number of digits $D_i$ of the difference value is less than the effective carry threshold N, the life is not configured to be calculated. Consequently, a carry that may be caused by fluctuation in bias current values can be reduced from being erroneously recognized as a carry caused by deterioration of the optical module 2. When the difference value of the bias current value from the initial bias current is small, a carry is likely to occur due to fluctuation. Therefore, when the number of digits $D_i$ of the difference value is less than the effective carry threshold N, the life is not calculated, whereby a carry caused by fluctuation can be reduced from being erroneously recognized as a carry caused by deterioration.

Second Embodiment.

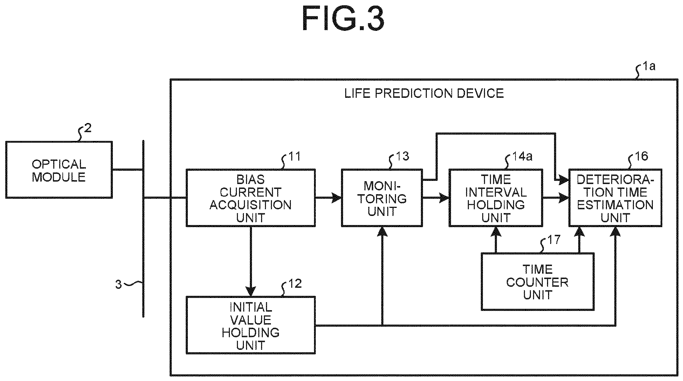

FIG. 3 is a diagram illustrating an exemplary configuration of a life prediction device according to the second embodiment of the invention, which is an alternative embodiment to that of fig. 1. As illustrated in FIG. 3, the life prediction device 1a of the present embodiment is the same as the life prediction device 1 of the first embodiment except that it includes a time interval holding unit 14a, a deterioration time estimation unit 16, and a time counter unit 17 instead of the time interval holding unit 14 and the life calculation unit 15 of the first embodiment. Components having the same functions as those in the first embodiment are denoted by the same reference signs as those in the first embodiment, and redundant explanations are omitted. Hereinafter, differences from the first embodiment will be mainly described.

The time counter unit 17 outputs time information indicating the current time to the time interval holding unit 14a. In response to being notified of the detection of a carry by the monitoring unit 13, the time interval holding unit 14a holds the time of the notification of the carry detection based on the time information output from the time counter unit 17. In response to being notified of the detection of a carry by the monitoring unit 13, the time interval holding unit 14a also calculates and holds a time difference value, i.e. the difference value between the time of the notification of the carry detection and the time previously held, based on the time information output from the time counter unit 17. The time interval holding unit 14a also calculates and holds the time interval $\Delta T$ using the held time difference value. The time interval holding unit 14a may set the latest difference value as the time interval $\Delta T$, or set the minimum value, average value, weighted average value, or the like of a plurality of held time difference values within a certain period of time as the time interval $\Delta T$. Alternatively, the time interval holding unit 14a may set the average value of the previous time interval $\Delta T$ and the latest difference value as the time interval $\Delta T$.

The deterioration time estimation unit 16 calculates and holds the difference value threshold $D_{limit}$ which is the threshold of the difference value between the bias current threshold, and the initial bias current value held by the initial value holding unit 12. As in the first embodiment, the bias current threshold may be set in advance in the life prediction device 1a, or may be set externally after the life prediction device 1a is started. Alternatively, the difference value threshold $D_{limit}$ may be set in the deterioration time estimation unit 16 instead of the bias current threshold.

The deterioration time estimation unit 16 estimates the estimated deterioration time of the optical module 2 as the life of the optical module 2 using the number of digits $D_i$ of the difference value calculated by the monitoring unit 13, the time interval $\Delta T$ held by the time interval holding unit 14a, and the time information output from the time counter unit 17.

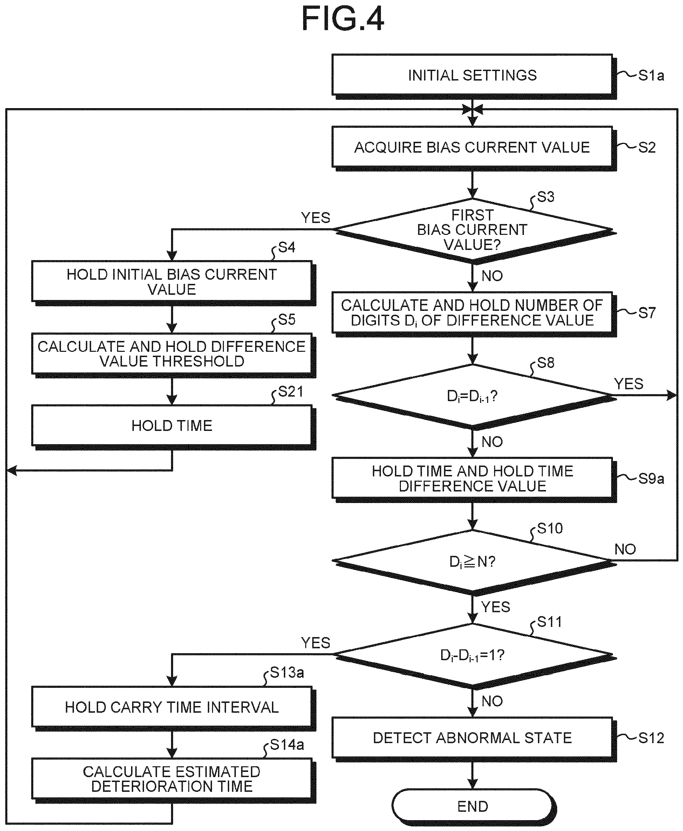

Next, a life prediction method for the optical module 2 by the life prediction device 1a of the present embodiment will be described. FIG. 4 is a flowchart illustrating an exemplary procedure in the life prediction device 1a.

First, the life prediction device 1a configures initial settings (step S1a). As initial settings, the bias current threshold is set in the deterioration time estimation unit 16, the effective carry threshold N is set in the monitoring unit 13, and the current time is set in the time counter unit 17.

Steps S2 to S5 are the same as those in the first embodiment. In the present embodiment, the data passed from each unit to the life calculation unit 15 in the first embodiment are passed to the deterioration time estimation unit 16 instead of the life calculation unit 15. Step S5 is performed by the deterioration time estimation unit 16 instead of the life calculation unit 15. After step S5, the time interval holding unit 14a holds the current time based on the time information acquired from the time counter unit 17 (step S21). After step S21, the processing returns to step S2.

When No is selected in step S3, steps S7 and S8 are performed as in the first embodiment. When No is selected in step S8, the time interval holding unit 14a holds the time, that is, the current time, based on the time information acquired from the time counter unit 17, and calculates and holds a time difference value, namely the difference value between the current time and the time previously held (step S9a). After step S9a, steps S10 and S11 are performed as in the first embodiment. Step S12 is also the same as that in the first embodiment.

When the value obtained by subtracting the number of digits $D_{i-1}$ from the number of digits $D_i$ is one (step S11: Yes), the monitoring unit 13 instructs the time interval holding unit 14a to hold the time interval $\Delta T$ that is the time interval for carry, and the time interval holding unit 14a holds the time difference value held in step S9a as the time interval $\Delta T$ (step S13a). In the same manner as the time interval holding unit 14 of the first embodiment, the time interval holding unit 14a may hold the latest time difference value as the time interval $\Delta T$, or may hold a plurality of time difference values to calculate the time interval $\Delta T$ from these time difference values or set the average value of these time difference values and the latest time difference value as the time interval $\Delta T$.

The deterioration time estimation unit 16 calculates the estimated deterioration time $T_T$ as the life of the optical module 2 using the difference value threshold $D_{limit}$, the number of digits $D_i$, the time interval $\Delta T$, and the time t that is the time of the calculation of the life, namely the time indicated by the time information output from the time counter unit 17 (step S14a). After step S14a, the processing returns to step S2. In step S14a, specifically, the deterioration time estimation unit 16 calculates the estimated deterioration time $T_T$ of the optical module 2 using Formula (2) below.

$$T_T = t + (D_{limit} - D_i) \times \Delta T \ldots \quad (2)$$

As described above, in the present embodiment, as in the first embodiment, the bias current is approximated with an exponential function with respect to time, whereby the estimated deterioration time of the optical module 2 is estimated based on the number of digits of the difference value between the bias current and the initial bias current and the carry time interval for the difference value. Consequently, the estimated deterioration time of the optical module 2 can be estimated accurately, as compared with the case where the estimated deterioration time is calculated by linear approximation between two times. In addition, the estimated deterioration time of the optical module 2 is obtained by providing the time counter unit 17, which is especially effective when the life prediction device 1a cannot provide notification of a calculated value to the outside in real time.

Third Embodiment.

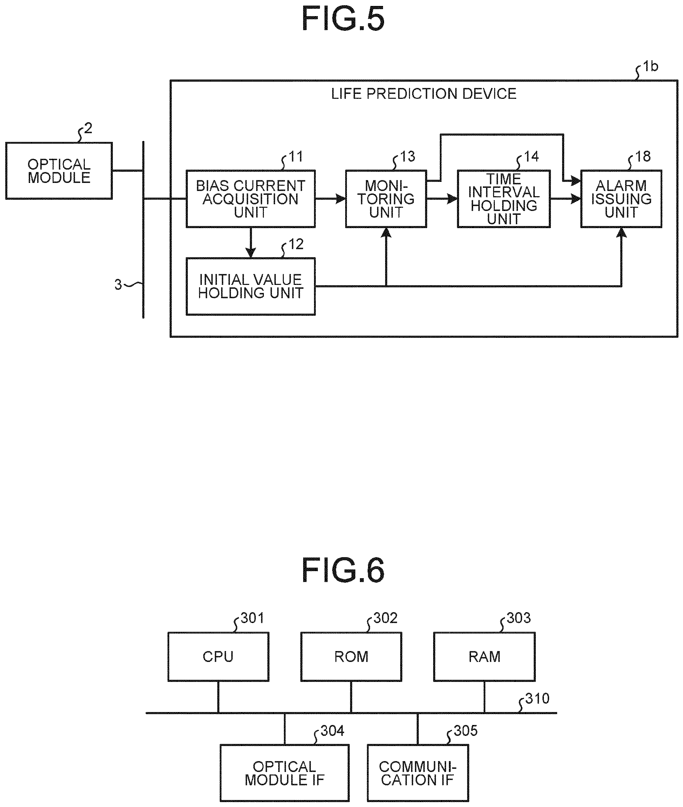

FIG. 5 is a diagram illustrating an exemplary configuration of a life prediction device according to a preferred embodiment. As illustrated in FIG. 5, the life prediction device 1b of the present embodiment is the same as the life prediction device 1 of the first embodiment except that it includes an alarm issuing unit 18 instead of the life calculation unit 15 of the first embodiment. Components having the same functions as those in the first embodiment are denoted by the same reference signs as those in the first embodiment, and redundant explanations are omitted. Hereinafter, differences from the first embodiment will be mainly described.

The alarm issuing unit 18 has a function as the life calculation unit 15 of the first embodiment and also has the alarm issuing function described below. That is, the function of the alarm issuing unit 18 corresponding to the life calculation unit 15 is the same as that in the first embodiment.

The alarm issuing unit 18 calculates the remaining life $T_L$ using Formula (1) above as described in the first embodiment, and when the remaining life $T_L$ is equal to or less than a preset threshold that is a second threshold, issues an alarm. An alarm may be issued, for example, by displaying an indication that the remaining life $T_L$ is equal to or less than the threshold on a display unit (not illustrated), or by transmitting information indicating that the remaining life $T_L$ is equal to or less than the threshold to an external device (not illustrated) through communication. The threshold about the remaining life $T_L$ can be, for example, the maintenance cycle for the optical module 2. Alternatively, a plurality of such thresholds having different values may be set, and the alarm issuing unit 18 may indicate the extent of the remaining life $T_L$ using the plurality of thresholds. For example, three thresholds $A_1$, $A_2$, and $A_3$ that satisfy $A_1 < A_2 < A_3$ ($A_1$, $A_2$, and $A_3$ are positive real numbers) are set for classifying the remaining life $T_L$ as the first level equal to or less than $A_3$ and greater than $A_2$, the second level equal to or less than $A_2$ and greater than $A_1$, or the third level equal to or less than $A_1$. The alarm issuing unit 18 can provide the extent of the remaining life $T_L$ to the outside by issuing information indicating which of the first, second, and third levels the remaining life $T_L$ is at.

As described above, the alarm issuing unit 18 issues an alarm when the remaining life $T_L$ is equal to or less than the threshold. Therefore, the amount of information transmitted to the outside can be reduced, as compared with the case where information indicating the remaining life $T_L$ is transmitted to the outside every time the remaining life $T_L$ is calculated.

Next, hardware configurations of the life prediction devices described in the first to third embodiments will be described. FIG. 6 is a diagram illustrating an exemplary hardware configuration of a life prediction device. The life prediction device includes a central processing unit (CPU) 301 as a processor, a read only memory (ROM) 302, a random access memory (RAM) 303, an optical module interface circuit (optical module IF) 304, and a communication interface circuit (communication IF) 305. These components are connected by a bus 310. The CPU 301 controls the entire life prediction device. The ROM 302 stores programs such as a boot program, a communication program, and a data analysis program. The ROM 302 stores a program for implementing the function as the life prediction device of the present embodiment, and the CPU 301 executes the program, whereby the operation of each unit of the life prediction device illustrated in FIGS. 1, 3, and 5 is implemented. The RAM 303 is used as a work area of the CPU 301. The optical module IF 304 functions as an interface for acquiring the bias current of the optical module. The communication IF 305 functions as an interface between the life prediction device and the outside.

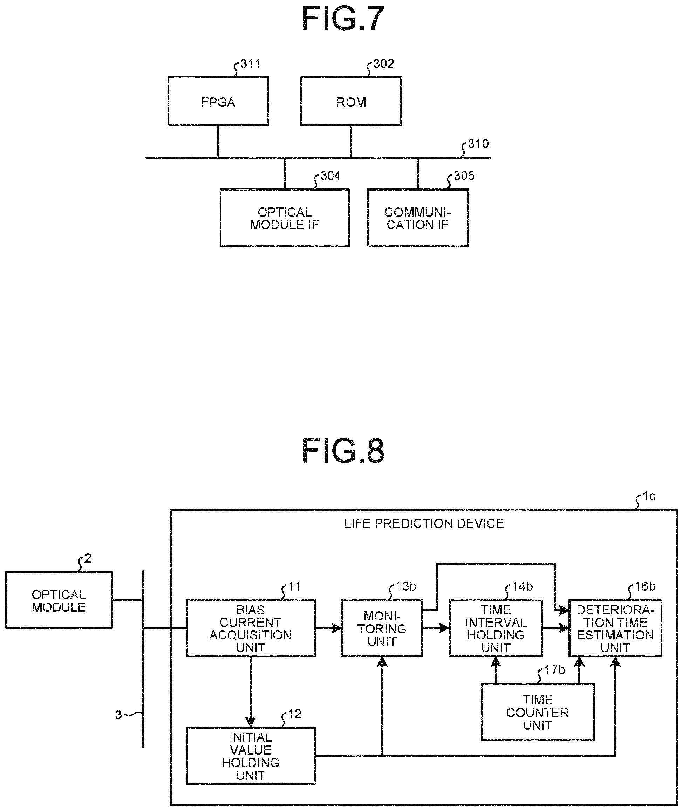

FIG. 7 is a diagram illustrating another exemplary hardware configuration of a life prediction device. The life prediction device includes a field programmable gate array (FPGA) 311, the ROM 302, the optical module IF 304, and the communication IF 305. These components are connected by the bus 310. The FPGA 311 controls the entire life prediction device. The ROM 302 stores a program for the FPGA 311. The ROM 302 may not be required depending on the type of the FPGA 311. The operation of each unit of the life prediction device illustrated in FIGS. 1, 3, and 5 is implemented by the FPGA 311. The optical module IF 304 functions as an interface for acquiring the bias current of the optical module. The communication IF 305 functions as an interface between the life prediction device and the outside. Note that some of the units of the life prediction device illustrated in FIGS. 1, 3, and 5 may be implemented using the CPU 301, and the rest may be implemented by the FPGA 311.

Fourth Embodiment.

FIG. 8 is a diagram illustrating an exemplary configuration of a life prediction device according to an exemplary embodiment, not falling under the scope of the invention. As illustrated in FIG. 8, the life prediction device 1c of the present embodiment is the same as the life prediction device 1a of the second embodiment except that it includes a monitoring unit 13b, a time interval holding unit 14b, a deterioration time estimation unit 16b, and a time counter unit 17b instead of the monitoring unit 13, the time interval holding unit 14a, the deterioration time estimation unit 16, and the time counter unit 17 of the second embodiment. Components having the same functions as those in the second embodiment are denoted by the same reference signs as those in the second embodiment, and redundant explanations are omitted. Hereinafter, differences from the second embodiment will be mainly described.

The monitoring unit 13b performs detection of the maximum value of the bias current output from the bias current acquisition unit 11 within a fixed cycle, in addition to detection of a carry, notification of the carry detection, and notification of the number of digits as described in the second embodiment. That is, the monitoring unit 13b calculates the maximum bias current value within a fixed cycle of bias current values in each fixed cycle. The monitoring unit 13b also notifies the time interval holding unit 14b of the detection of the maximum bias current value, and notifies the deterioration time estimation unit 16b of the maximum bias current value. Note that the monitoring unit 13b compares, for example, the first bias current value and the second bias current value detected within a fixed cycle, and notifies the time interval holding unit 14b of the larger one as the temporary maximum value. The time interval holding unit 14b temporarily holds the time of the notification of the maximum value based on the time information output from the time counter unit 17b. Thereafter, the monitoring unit 13b sequentially compares the next bias current value detected and the current maximum value within the fixed cycle, and when the detected bias current value is larger, notifies the time interval holding unit 14b of the detection of the maximum value. Then, when the one fixed cycle ends, the monitoring unit 13b notifies the time interval holding unit 14b of the end of the fixed cycle. Consequently, the time interval holding unit 14b determines the detection time of the maximum value in this fixed cycle. Note that the method of calculating the maximum value detection time in a fixed cycle is not limited to the above-described example.

The time counter unit 17b outputs time information indicating the current time to the time interval holding unit 14b. In response to being notified of the detection of a carry by the monitoring unit 13b, the time interval holding unit 14b holds the time of the notification of the carry detection based on the time information output from the time counter unit 17b. In response to being notified of the detection of a carry by the monitoring unit 13b, the time interval holding unit 14b also calculates and holds the time interval $\Delta T$ using a time difference value, namely the difference value between the time of the notification of the carry detection and the carry time previously held, based on the time information output from the time counter unit 17b. The time interval holding unit 14b also calculates and holds the time interval $\Delta T$ using the held time difference value. The time interval holding unit 14b may hold the latest difference value as the time interval $\Delta T$, or may store a plurality of time difference values within a fixed period of time to hold the minimum value, average value, weighted average value, or the like of the plurality of stored time difference values as the time interval $\Delta T$. The time interval holding unit 14b may hold the average value of the previous time interval $\Delta T$ and the latest difference value as the time interval $\Delta T$.

When being notified of the detection of a maximum bias current value by the monitoring unit 13b, the time interval holding unit 14b also holds the time of the notification of the maximum bias current value detection based on the time information output from the time counter unit 17b. The time interval holding unit 14b also outputs, in each fixed cycle, the time of the notification of the maximum bias current value detection to the deterioration time estimation unit 16b as the maximum value detection time. As described above, the monitoring unit 13b detects the maximum bias current value in a fixed cycle, so the time interval holding unit 14b can obtain one maximum value detection time per fixed cycle from the monitoring unit 13b.

The deterioration time estimation unit 16b calculates and holds the difference value threshold $D_{limit}$ which is the threshold of the difference value between the bias current threshold and the initial bias current value held by the initial value holding unit 12. As in the second embodiment, the bias current threshold may be set in advance in the life prediction device 1c, or may be set externally after the life prediction device 1c is started. Alternatively, the difference value threshold $D_{limit}$ may be set in the deterioration time estimation unit 16b instead of the bias current threshold.

The deterioration time estimation unit 16b estimates the first estimated deterioration time $T_{T1}$ of the optical module 2 as the life of the optical module 2 using the number of digits $D_i$ of the difference value calculated by the monitoring unit 13b, the time interval $\Delta T$ held by the time interval holding unit 14b, and the time information output from the time counter unit 17b. The method of calculating the first estimated deterioration time $T_{T1}$ is the same as the method of calculating the estimated deterioration time described in the second embodiment.

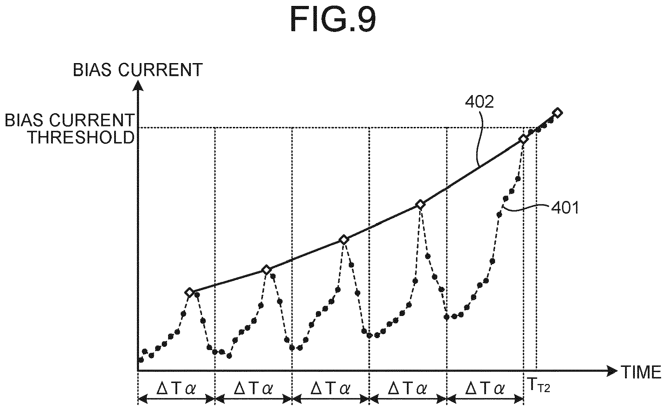

The deterioration time estimation unit 16b also estimates the estimated deterioration time of the optical module 2 based on the maximum bias current value within a fixed cycle of bias current values and the time of the detection of the maximum bias current value. Specifically, using the maximum bias current value provided by the monitoring unit 13b and the maximum value detection time output from the time interval holding unit 14b, the deterioration time estimation unit 16b calculates a life prediction function F(T) that is based on the temperature characteristics of the laser caused by temperature changes on a daily basis or a seasonal basis. FIG. 9 is a diagram schematically illustrating the life prediction function F(T) that is based on the temperature characteristics of the laser according to the example of fig. 8. In FIG. 9, the horizontal axis represents time, and the vertical axis represents bias current. The bias current 401 indicates the bias current acquired by the bias current acquisition unit 11. The fixed cycle $\Delta T\alpha$ is a cycle in which the monitoring unit 13b detects a maximum bias current value. That is, the monitoring unit 13b detects the maximum bias current value output from the bias current acquisition unit 11 in each fixed cycle $\Delta T\alpha$. The approximate curve 402 is an approximate curve that approximates the relationship between time and bias current using the maximum bias current value output from the monitoring unit 13b and the maximum value detection time output from the time interval holding unit 14b. The life prediction function F(T) that is based on the temperature characteristics of the laser is represented by this approximate curve 402.

The deterioration time estimation unit 16b estimates the second estimated deterioration time $T_{T2}$ of the optical module 2 using the calculated life prediction function F(T) that is based on the temperature characteristics of the laser and the bias current threshold. Specifically, the deterioration time estimation unit 16b obtains the time at which the value of the life prediction function F(T) that is based on the temperature characteristics of the laser is equal to the bias current threshold, and sets the obtained time as the second estimated deterioration time $T_{T2}$.

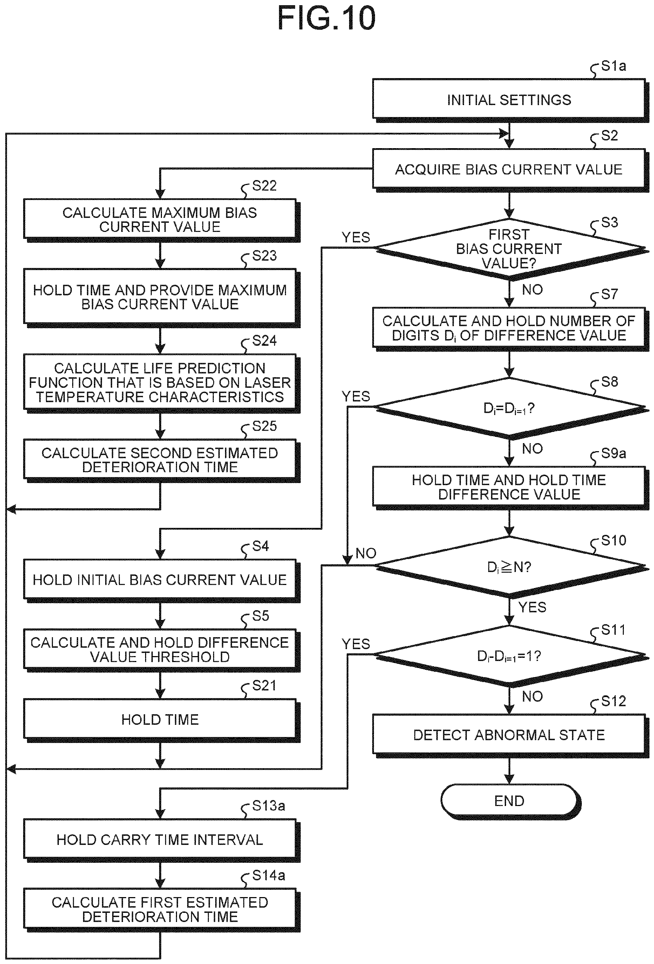

Next, a life prediction method for the optical module 2 by the life prediction device 1c of the present embodiment will be described. FIG. 10 is a flowchart illustrating an exemplary procedure in the life prediction device 1c according to the exemplary embodiment of fig. 8.

First, the life prediction device 1c configures initial settings (step S1a). As initial settings, the bias current threshold is set in the deterioration time estimation unit 16b, the effective carry threshold N is set in the monitoring unit 13b, and the current time is set in the time counter unit 17b.

Steps S2 to S5 are the same as those in the second embodiment. In the present embodiment, the data passed from each unit to the deterioration time estimation unit 16 in the second embodiment are passed to the deterioration time estimation unit 16b instead of the deterioration time estimation unit 16. Step S5 is performed by the deterioration time estimation unit 16b instead of the deterioration time estimation unit 16. After step S5, the time interval holding unit 14b holds the current time based on the time information acquired from the time counter unit 17b (step S21). After step S21, the processing returns to step S2.

When No is selected in step S3, steps S7 and S8 are performed as in the second embodiment. When No is selected in step S8, the time interval holding unit 14b holds the time, that is, the current time, based on the time information acquired from the time counter unit 17b, and calculates and holds a time difference value, namely the difference value between the current time and the time previously held (step S9a). After step S9a, steps S10 and S11 are performed as in the second embodiment. Step S12 is also the same as that in the second embodiment.

When the value obtained by subtracting the number of digits $D_{i-1}$ from the number of digits $D_i$ is one (step S11: Yes), the monitoring unit 13b instructs the time interval holding unit 14b to hold the time interval $\Delta T$ that is the time interval for carry, and the time interval holding unit 14b holds the time difference value held in step S9a as the time interval $\Delta T$ (step S13a). In the same manner as the time interval holding unit 14a of the second embodiment, the time interval holding unit 14b may hold the latest time difference value as the time interval $\Delta T$, or may hold a plurality of time difference values to calculate the time interval $\Delta T$ from these time difference values or set the average value of these time difference values and the latest time difference value as the time interval $\Delta T$.

The deterioration time estimation unit 16b calculates the first estimated deterioration time $T_{T1}$ as the life of the optical module 2 using the difference value threshold $D_{limit}$, the number of digits $D_i$, the time interval $\Delta T$, and the time t that is the time of the calculation of the life, namely the time indicated by the time information output from the time counter unit 17b (step S14a). After step S14a, the processing returns to step S2. In step S14a, specifically, the deterioration time estimation unit 16b calculates the first estimated deterioration time $T_{T1}$ of the optical module 2 using Formula (3) below.

$$T_{T1} = t + (D_{limit} - D_i) \times \Delta T \dots \quad (3)$$

After step S2, step S22 is performed in parallel with step S3. Step S22 is the process in which the monitoring unit 13b calculates the maximum bias current value within a fixed cycle output from the bias current acquisition unit 11. After step S22, step S23 is performed.

In step S23, the time interval holding unit 14b holds the time, that is, the time of the calculation of the maximum value, based on the time information acquired from the time counter unit 17b. The maximum bias current value calculated by the monitoring unit 13b is provided to the deterioration time estimation unit 16b. After step S23, step S24 is performed.

In step S24, the deterioration time estimation unit 16b calculates the life prediction function F(T) that is based on the temperature characteristics of the laser using the maximum bias current value provided by the monitoring unit 13b and the time information of the notification of the maximum bias current value detection output from the time interval holding unit 14b. After step S24, step S25 is performed.

In step S25, the deterioration time estimation unit 16b calculates the second estimated deterioration time $T_{T2}$ of the optical module 2 using the life prediction function F(T) that is based on the temperature characteristics of the laser calculated in step S24 and the bias current threshold set in step S1a.

In the above example, after step S2, the life prediction device 1c performs both the process that starts at step S3, that is, the process similar to that in the second embodiment, and the process of steps S22 to S25. Alternatively, only the process of steps S22 to S25 may be performed after step S2. As described above, the life prediction method for an optical module according to the present embodiment includes a step of calculating a maximum bias current value within a fixed cycle of the bias current values in each fixed cycle, and a step of estimating an estimated deterioration time of the optical module based on the maximum bias current value and a time of detection of the maximum bias current value.

As described above, in the present embodiment, as in the second embodiment, the bias current is approximated with an exponential function with respect to time, whereby the estimated deterioration time of the optical module 2 is estimated based on the number of digits of the difference value between the bias current and the initial bias current and the carry time interval for the difference value. Consequently, the estimated deterioration time of the optical module 2 can be estimated accurately, as compared with the case where the estimated deterioration time is calculated by linear approximation between two times. In addition, the estimated deterioration time of the optical module 2 is obtained by providing the time counter unit 17b, which is especially effective when the life prediction device 1c cannot provide notification of a calculated value to the outside in real time. Further, the life prediction function F(T) that is based on the temperature characteristics of the laser is calculated on the basis of the maximum bias current value and the time information of the notification of the maximum bias current value detection, and the estimated deterioration time of the optical module 2 is estimated on the basis of the life prediction function F(T) that is based on the temperature characteristics of the laser and the bias current threshold. Consequently, the estimated deterioration time can be calculated in consideration of the temperature characteristics of the laser.

Reference Signs List

1, 1a, 1b, 1c life prediction device; 2 optical module; 3 bus; 11 bias current acquisition unit; 12 initial value holding unit; 13, 13b monitoring unit; 14, 14a, 14b time interval holding unit; 15 life calculation unit; 16, 16b deterioration time estimation unit; 17, 17b time counter unit; 18 alarm issuing unit.

**Claims**

1. A life prediction method for an optical module (2), the optical module (2) being configured to keep optical output constant by controlling a bias current that is applied to a laser diode, the method comprising the following method steps, which are carried out by a life prediction device (1; 1a; 1b):

   a first step of acquiring, by a bias current acquisition unit (11) of the life prediction device (1; 1a; 1b) and from the optical module (2), a bias current value that is a current value of the bias current;
   a second step of holding, by an initial value holding unit (12) of the life prediction device (1; 1a; 1b), an initial bias current value that is an initial current value of the bias current;
   a third step of calculating, by a monitoring unit (13; 13b) of the life prediction device (1; 1a; 1b), a number of digits of a difference value between the bias current value and the initial bias current value, and determining whether there is an increase in the number of digits;
   a fourth step of calculating, by a time interval calculation unit (14; 14a; 14b) of the life prediction device (1; 1a; 1b), a time interval at which occurrence of the increase in the number of digits is detected; and
   a fifth step of estimating, by a life calculation unit (15; 18; 16b) of the life prediction device (1; 1a; 1b), a life of the optical module (2) using the time interval, a first threshold and the number of digits;
   wherein the life is a remaining life of the optical module (2), and wherein the life calculation unit (15; 18; 16b) calculates the remaining life of the optical module (2) according to

$$TL = (Dlimit - Di) * \Delta T;$$

or
wherein the life is an estimated deterioration time of the optical module (2), and wherein the life calculation unit (15; 18; 16b) calculates the estimated deterioration time of the optical module (2) according to

$$TT = t + (Dlimit - Di) * \Delta T;$$

where TL denotes the remaining life of the optical module (2), TT denotes the estimated deterioration time of the optical module (2), Dlimit denotes the first threshold and is the number of digits of the difference value of the initial bias current value and a bias current threshold for which it is determined that the optical module has deteriorated, Di denotes the number of digits of the difference value between the i-th bias current value acquired and the initial bias current value, where i is an integer equal to two or more, ΔT denotes the time interval, and t denotes a time of the calculation of the life.

2. The life prediction method for an optical module (2) according to claim 1, comprising
a sixth step of issuing an alarm when the remaining life is equal to or less than a second threshold set in advance.

3. A life prediction device (1; 1a; 1b) that predicts a life of an optical module (2), the optical module (2) being configured to keep optical output constant by controlling a bias current that is applied to a laser diode, the life prediction device comprising:

a bias current acquisition unit (11) to acquire, from the optical module (2), a bias current value that is a current value of the bias current;
an initial value holding unit (12) to hold an initial bias current value that is an initial current value of the bias current;
a monitoring unit (13; 13b) to calculate a number of digits of a difference value between the bias current value and the initial bias current value, and determine whether there is an increase in the number of digits;
a time interval calculation unit (14; 14a; 14b) to calculate a time interval at which occurrence of the increase in the number of digits is detected; and
a life calculation unit (15; 18; 16b) to estimate the life of the optical module (2) using the time interval, a first threshold and the number of digits;
wherein the life is a remaining life of the optical module (2), and wherein the life calculation unit (15; 18; 16b) is configured to calculate the remaining life of the optical module (2) according to

$$TL = (Dlimit - Di) * \Delta T;$$

or
wherein the life is an estimated deterioration time of the optical module (2), and wherein the life calculation unit (15; 18; 16b) is configured to calculate the estimated deterioration time of the optical module (2) according to

$$TT = t + (Dlimit - Di) * \Delta T;$$

where TL denotes the remaining life of the optical module (2), TT denotes the estimated deterioration time of the optical module (2), Dlimit denotes the first threshold and is the number of digits of the difference value of the initial bias current value and a bias current threshold for which it is determined that the optical module has deteriorated, Di denotes the number of digits of the difference value between the i-th bias current value acquired and the initial bias current value, where i is an integer equal to two or more, ΔT denotes the time interval, and t denotes a time of the calculation of the life.

4. The life prediction device (1a) according to claim 3, wherein an alarm is issued when the remaining life is equal to or less than a second threshold set in advance.

**Patentansprüche**

1. Lebensdauervorhersageverfahren für ein optisches Modul (2), wobei das optische Modul (2) eingerichtet ist, eine optische Ausgabe konstant zu halten, indem ein Vorspannungsstrom gesteuert wird, der an eine Laserdiode angelegt ist, wobei das Verfahren die folgenden Verfahrensschritte umfasst, die von einer Lebensdauervorhersageeinrichtung (1; 1a; 1b) ausgeführt werden:

einen ersten Schritt des Beschaffens eines Vorspannungsstromwertes, der ein aktueller Wert des Vorspannungsstromes ist, durch eine Vorspannungsstrombeschaffungseinheit (11) der Lebensdauervorhersageeinrichtung (1; 1a; 1b) und von dem optischen Modul (2);

einen zweiten Schritt des Haltens eines anfänglichen Vorspannungsstromwertes, der ein anfänglicher Stromwert des Vorspannungsstromes ist, durch eine Anfangswert-Halteeinheit (12) der Lebensdauervorhersageeinrichtung (1; la; 1b);

einen dritten Schritt des Berechnens einer Anzahl von Ziffern eines Differenzwertes zwischen dem Vorspannungsstromwert und dem anfänglichen Vorspannungsstromwert und des Bestimmens, ob es eine Zunahme der Anzahl von Ziffern gibt, durch eine Überwachungseinheit (13; 13b) der Lebensdauervorhersageeinrichtung (1; la; 1b);

einen vierten Schritt des Berechnens eines Zeitintervalls der Lebensdauervorhersageeinrichtung (1; 1a; 1b), bei dem ein Auftreten der Zunahme der Anzahl von Ziffern erfasst wird, durch eine Zeitintervallberechnungseinheit (14; 14a; 14b) ; und

einen fünften Schritt des Schätzens einer Lebensdauer des optischen Moduls (2) unter Verwendung des Zeitintervalls, eines ersten Schwellenwerts und der Anzahl von Ziffern, durch eine Lebensdauerberechnungseinheit (15; 18; 16b) der Lebensdauervorhersageeinrichtung (1; 1a; 1b);

wobei die Lebensdauer eine verbleibende Lebensdauer des optischen Moduls (2) ist, und wobei die Lebensdauerberechnungseinheit (15; 18; 16b) die verbleibende Lebensdauer des optischen Moduls (2) berechnet gemäß

$$TL = (Dlimit - Di) * \Delta T;$$

oder

wobei die Lebensdauer eine geschätzte Verschlechterungszeit des optischen Moduls (2) ist, und wobei die Lebensdauerberechnungseinheit (15; 18; 16b) die geschätzte Verschlechterungszeit des optischen Moduls (2) berechnet gemäß

$$TT = t + (Dlimit - Di) * \Delta T;$$

wobei TL die verbleibende Lebensdauer des optischen Moduls (2) bezeichnet, TT die geschätzte Verschlechterungszeit des optischen Moduls (2) bezeichnet, Dlimit den ersten Schwellenwert bezeichnet und der Anzahl von Ziffern des Differenzwerts zwischen dem anfänglichen Vorspannungsstromwert und einem Vorspannungsstromschwellenwert entspricht, für den bestimmt wird, dass sich das optische Modul verschlechtert hat, Di die Anzahl von Ziffern des Differenzwertes zwischen dem i-ten beschafften Vorspannungsstromwert und dem anfänglichen Vorspannungsstromwert bezeichnet, wo i eine ganze Zahl gleich zwei oder mehr ist, $\Delta T$ das Zeitintervall bezeichnet und t einen Zeitpunkt der Berechnung der Lebensdauer bezeichnet.

2. Lebensdauervorhersageverfahren für ein optisches Modul (2) nach Anspruch 1, umfassend
einen sechsten Schritt des Auslösens eines Alarms, wenn die verbleibende Lebensdauer gleich wie oder geringer als ein im Voraus eingestellter zweiter Schwellenwert ist.

3. Lebensdauervorhersageeinrichtung (1; 1a; 1b), die eine Lebensdauer eines optischen Moduls (2) vorhersagt, wobei das optische Modul (2) eingerichtet ist, eine optische Ausgabe konstant zu halten, indem ein Vorspannungsstrom gesteuert wird, der an eine Laserdiode angelegt wird, wobei die Lebensdauervorhersageeinrichtung umfasst:

eine Vorspannungsstrombeschaffungseinheit (11) zum Beschaffen eines Vorspannungsstromwertes, der ein Stromwert des Vorspannungsstroms ist, von dem optischen Modul (2);

eine Anfangswert-Halteeinheit (12) zum Halten eines anfänglichen Vorspannungsstromwertes, der ein anfänglicher Stromwert des Vorspannungsstromes ist;

eine Überwachungseinheit (13; 13b) zum Berechnen einer Anzahl von Ziffern eines Differenzwertes zwischen dem Vorspannungsstromwert und dem anfänglichen Vorspannungsstromwert und zum Bestimmen, ob es eine Zunahme der Anzahl von Ziffern gibt;

eine Zeitintervallberechnungseinheit (14; 14a; 14b) zum Berechnen eines Zeitintervalls, bei dem ein Auftreten der Zunahme der Anzahl von Ziffern erfasst wird; und

eine Lebensdauerberechnungseinheit (15; 18; 16b) zum Schätzen der Lebensdauer des optischen Moduls (2) unter Verwendung des Zeitintervalls, eines ersten Schwellenwerts und der Anzahl von Ziffern;

wobei die Lebensdauer eine verbleibende Lebensdauer des optischen Moduls (2) ist, und wobei die Lebensdauerberechnungseinheit (15; 18; 16b) eingerichtet ist, die verbleibende Lebensdauer des optischen Moduls (2) zu berechnen gemäß

$$TL = (Dlimit - Di) * \Delta T;$$

oder

wobei die Lebensdauer eine geschätzte Verschlechterungszeit des optischen Moduls (2) ist, und wobei die Lebensdauerberechnungseinheit (15; 18; 16b) eingerichtet ist, die geschätzte Verschlechterungszeit des optischen Moduls (2) zu berechnen gemäß

$$TT = t + (Dlimit - Di) * \Delta T;$$

wobei TL die verbleibende Lebensdauer des optischen Moduls (2) bezeichnet, TT die geschätzte Verschlechterungszeit des optischen Moduls (2) bezeichnet, Dlimit den ersten Schwellenwert bezeichnet und der Anzahl von Ziffern des Differenzwerts zwischen dem anfänglichen Vorspannungsstromwert und einem Vorspannungsstromschwellenwert entspricht, für den bestimmt wird, dass sich das optische Modul verschlechtert hat, Di die Anzahl von Ziffern des Differenzwertes zwischen dem i-ten beschafften Vorspannungsstromwert und dem anfänglichen Vorspannungsstromwert bezeichnet, wo i eine ganze Zahl gleich zwei oder mehr ist, $\Delta T$ das Zeitintervall bezeichnet und t einen Zeitpunkt der Berechnung der Lebensdauer bezeichnet.

4. Lebensdauervorhersageeinrichtung (1a) nach Anspruch 3, wobei ein Alarm ausgelöst wird, wenn die verbleibende Lebensdauer gleich wie oder geringer als ein im Voraus eingestellter zweiter Schwellenwert ist.

## Revendications

1. Procédé de prédiction de la durée de vie d'un module optique (2), le module optique (2) étant configuré pour maintenir la sortie optique constante en contrôlant un courant de polarisation appliqué à une diode laser, le procédé comprenant les étapes suivantes, qui sont exécutées par un dispositif de prédiction de la durée de vie (1 ; 1a ; 1b) :

une première étape d'acquisition, par une unité d'acquisition de courant de polarisation (11) du dispositif de prédiction de la durée de vie (1 ; 1a ; 1b) et à partir du module optique (2), d'une valeur de courant de polarisation qui est une valeur actuelle du courant de polarisation ;

une deuxième étape de maintien, par une unité de maintien de la valeur initiale (12) du dispositif de prédiction de la durée de vie (1 ; 1a ; 1b), d'une valeur de courant de polarisation initiale qui est une valeur de courant initiale du courant de polarisation ;

une troisième étape consistant à calculer, par une unité de surveillance (13 ; 13b) du dispositif de prévision de la durée de vie (1 ; 1a ; 1b), un nombre de chiffres d'une valeur de différence entre la valeur du courant de polarisation et la valeur initiale du courant de polarisation, et à déterminer s'il y a une augmentation du nombre de chiffres ;

une quatrième étape consistant à calculer, par une unité de calcul d'intervalle de temps (14 ; 14a ; 14b) du dispositif de prédiction de la durée de vie (1 ; 1a ; 1b), un intervalle de temps au cours duquel l'augmentation du nombre de chiffres est détectée ; et

une cinquième étape consistant à estimer, par une unité de calcul de la durée de vie (15 ; 18 ; 16b) du dispositif de prédiction de la durée de vie (1 ; 1a ; 1b), la durée de vie du module optique (2) à l'aide de l'intervalle de temps, d'un premier seuil et du nombre de chiffres ;

dans lequel la durée de vie est une durée de vie restante du module optique (2), et dans lequel l'unité de calcul de la durée de vie (15 ; 18 ; 16b) calcule la durée de vie restante du module optique (2) en fonction de

$$TL = (Dlimit - Di) * \Delta T ;$$

ou
dans lequel la durée de vie est une durée de détérioration estimée du module optique (2), et dans lequel l'unité de calcul de la durée de vie (15 ; 18 ; 16b) calcule la durée de détérioration estimée du module optique (2) en fonction de

$$TT = t + (Dlimit - Di) * \Delta T ;$$

dans lequel TL représente la durée de vie restante du module optique (2), TT représente le temps de détérioration estimé du module optique (2), Dlimit représente le premier seuil et est le nombre de chiffres représentant la différence entre la valeur initiale du courant de polarisation et un seuil de courant de polarisation pour lequel il est déterminé que le module optique s'est détérioré, Di représente le nombre de chiffres de la différence entre la i-ième valeur de courant de polarisation acquise et la valeur initiale de courant de polarisation, où i est un nombre entier égal à deux ou plus, $\Delta T$ désigne l'intervalle de temps, et t désigne le moment du calcul de la durée de vie.

2. Procédé de prédiction de la durée de vie d'un module optique (2) selon la revendication 1, comprenant une sixième étape consistant à émettre une alarme lorsque la durée de vie restante est égale ou inférieure à un deuxième seuil fixé à l'avance.

3. Dispositif de prédiction de la durée de vie (1 ; 1a ; 1b) qui prédit la durée de vie d'un module optique (2), le module optique (2) étant configuré pour maintenir la sortie optique constante en contrôlant un courant de polarisation appliqué à une diode laser, le dispositif de prédiction de la durée de vie comprenant :

une unité d'acquisition du courant de polarisation (11) pour acquérir, à partir du module optique (2), une valeur de courant de polarisation qui est une valeur actuelle du courant de polarisation ;
une unité de maintien de la valeur initiale (12) pour maintenir une valeur initiale du courant de polarisation qui est une valeur initiale du courant de polarisation ;
une unité de surveillance (13 ; 13b) pour calculer un nombre de chiffres d'une valeur de différence entre la valeur du courant de polarisation et la valeur initiale du courant de polarisation, et déterminer s'il y a une augmentation du nombre de chiffres ;
une unité de calcul de l'intervalle de temps (14 ; 14a ; 14b) pour calculer un intervalle de temps à partir duquel l'augmentation du nombre de chiffres est détectée ; et
une unité de calcul de la durée de vie (15 ; 18 ; 16b) pour estimer la durée de vie du module optique (2) à l'aide de l'intervalle de temps, d'un premier seuil et du nombre de chiffres ;
dans lequel la durée de vie est une durée de vie restante du module optique (2), et dans lequel l'unité de calcul de la durée de vie (15 ; 18 ; 16b) est configurée pour calculer la durée de vie restante du module optique (2) en fonction de

$$TL = (Dlimit - Di) * \Delta T ;$$

ou
dans lequel la durée de vie est une durée de détérioration estimée du module optique (2), et dans lequel l'unité de calcul de la durée de vie (15 ; 18 ; 16b) est configurée pour calculer la durée de détérioration estimée du module optique (2) en fonction de

$$TT = t + (Dlimit - Di) * \Delta T ;$$

dans lequel TL représente la durée de vie restante du module optique (2), TT représente le temps de détérioration estimé du module optique (2), Dlimit représente le premier seuil et est le nombre de chiffres représentant la différence entre la valeur initiale du courant de polarisation et un seuil de courant de polarisation pour lequel il est déterminé que le module optique s'est détérioré, Di représente le nombre de chiffres de la différence entre la i-ième valeur de courant de polarisation acquise et la valeur initiale de courant de polarisation, où i est un nombre entier égal à deux ou plus, $\Delta T$ désigne l'intervalle de temps, et t désigne le moment du calcul de la durée de vie.

4. Dispositif de prédiction de la durée de vie (1a) selon la revendication 3, dans lequel une alarme est émise lorsque la durée de vie restante est égale ou inférieure à un deuxième seuil fixé à l'avance.

# FIG.1

LIFE PREDICTION DEVICE — 1

OPTICAL MODULE — 2

BIAS CURRENT ACQUISITION UNIT — 11

INITIAL VALUE HOLDING UNIT — 12

MONI-TORING UNIT — 13

TIME INTERVAL HOLDING UNIT — 14

LIFE CALCULA-TION UNIT — 15

3

# FIG.2

INITIAL SETTINGS ~S1

ACQUIRE BIAS CURRENT VALUE ~S2

FIRST BIAS CURRENT VALUE? S3

YES → HOLD INITIAL BIAS CURRENT VALUE S4

CALCULATE AND HOLD DIFFERENCE VALUE THRESHOLD S5

RESET TIMER S6

NO → CALCULATE AND HOLD NUMBER OF DIGITS $D_i$ OF DIFFERENCE VALUE ~S7

$D_i = D_{i-1}$? S8 YES

NO

HOLD AND RESET TIMER VALUE ~S9

$D_i \geqq N$? S10 NO

YES

$D_i - D_{i-1} = 1$? S11

YES → HOLD CARRY TIME INTERVAL S13

CALCULATE LIFE S14

NO → DETECT ABNORMAL STATE ~S12

END

# FIG.3

LIFE PREDICTION DEVICE ⟋1a

```
OPTICAL
MODULE    ⟋2
```

```
BIAS
CURRENT
ACQUISITION
UNIT    ⟋11
```

```
MONI-
TORING
UNIT    ⟋13
```

```
TIME
INTERVAL
HOLDING
UNIT    ⟋14a
```

```
DETERIORA-
TION TIME
ESTIMATION
UNIT    ⟋16
```

```
TIME
COUNTER
UNIT    ⟋17
```

```
INITIAL
VALUE
HOLDING
UNIT    ⟋12
```

3

# FIG.4

# FIG.5

# FIG.6

# FIG.7

```
┌──────────┐        ┌──────────┐
│  ⌐311    │        │  ⌐302    │
│  FPGA    │        │   ROM    │
└────┬─────┘        └────┬─────┘
     │                   │                    ⌐310
─────┴───────────────────┴──────────────────────────
            │                      │
       ⌐304 │                 ⌐305 │
   ┌─────────────┐        ┌──────────────┐
   │   OPTICAL   │        │  COMMUNI-    │
   │  MODULE IF  │        │  CATION IF   │
   └─────────────┘        └──────────────┘
```

# FIG.8

# FIG.9

# FIG.10

INITIAL SETTINGS ⟋S1a

ACQUIRE BIAS CURRENT VALUE ⟋S2

FIRST BIAS CURRENT VALUE? ⟋S3

YES → CALCULATE MAXIMUM BIAS CURRENT VALUE ⟋S22

HOLD TIME AND PROVIDE MAXIMUM BIAS CURRENT VALUE ⟋S23

CALCULATE LIFE PREDICTION FUNCTION THAT IS BASED ON LASER TEMPERATURE CHARACTERISTICS ⟋S24

CALCULATE SECOND ESTIMATED DETERIORATION TIME ⟋S25

NO → CALCULATE AND HOLD NUMBER OF DIGITS $D_i$ OF DIFFERENCE VALUE ⟋S7

$D_i = D_{i=1}$? ⟋S8

YES

NO → HOLD TIME AND HOLD TIME DIFFERENCE VALUE ⟋S9a

HOLD INITIAL BIAS CURRENT VALUE ⟋S4

CALCULATE AND HOLD DIFFERENCE VALUE THRESHOLD ⟋S5

HOLD TIME ⟋S21

NO → $D_i \geqq N$? ⟋S10

YES

$D_i - D_{i=1} = 1$? ⟋S11

YES

NO → DETECT ABNORMAL STATE ⟋S12

END

HOLD CARRY TIME INTERVAL ⟋S13a

CALCULATE FIRST ESTIMATED DETERIORATION TIME ⟋S14a

23

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2004167747 A1
- JP 2014107790 A
- JP H09116231 A